# EUROPEAN PATENT APPLICATION

(11) **EP 4 773 157 A1**
(43) Date of publication of application: **08.07.2026**
(21) Application number: 25227159.8
(22) Date of filing: 24.12.2025
(51) Int. Cl.: H01F 3/10, B60L 53/12, H01F 27/28, H01F 38/14, H01F 27/22

(54) **THREE PHASE MAGNETIC FLUX PAD FOR WIRELESS CHARGER**

(30) Priority: 03.01.2025 KR 20250001119; 08.12.2025 KR 20250192546
(71) Applicant: Green Power Co., Ltd., Hwaseong-si, Gyeonggi-do 18487 (KR)
(72) Inventor: Cho, Jung goo, Suwon-si, Gyeonggi-do (KR)
(74) Representative: Schön, Christoph

(57) **Abstract**

The present invention relates to a magnetic flux pad for transmitting and receiving wireless power for electric vehicles. In detail, three coils provided on a plane so as not to overlap each other are included, and the three coils are arranged adjacent to each other, and adjacent portions between the coils are configured to be parallel to each other. Each of the three coils includes an internal core arranged inside the coil, and three connection cores connecting the three internal cores are provided at the rear portions of the adjacent portions of each of the three coils. Here, the three internal cores and the three connection cores are connected to each other in an overlapping manner and are configured to have a structure overlapping by a width greater than a thickness of the connection core to form a three-phase coil. According to the structure of the three-phase magnetic flux pad of the present invention, high-output wireless power transmission is possible by improving the coupling coefficient of a wireless power transmission device, the power transmission and reception efficiency between a wireless power transmission device and the wireless power reception device may be enhanced.

## Description

### [Technical field]

The present invention relates to a magnetic flux pad for transmitting and receiving wireless power for electric vehicles. More specifically, the present invention relates to a three-phase coil structure for improving power transfer efficiency during wireless power transfer and a three-phase magnetic flux pad using the same.

### [Background Art]

The following description merely provides background information related to the present embodiment and does not constitute prior art.

Recently, as air pollution and environmental issues have emerged as global issues, the transition from internal combustion engine vehicles to electric vehicles has rapidly progressed.

Electric vehicle charging systems may take various forms depending on the type and may be primarily classified into conductive wired charging systems, which connect a charging cable via a plug-in method, and non-contact wireless charging systems based on magnetic induction.

In the wired charging system, the user has to directly connect a plug to charge a vehicle; in particular, fast chargers have the disadvantage that the process of inserting or removing the plug is very inconvenient due to the significant weight of the plug and a charging cable. In contrast, wireless charging systems are much more convenient than wired charging methods because charging may occur automatically just by parking the vehicle in a parking spot. Nevertheless, wireless charging systems have not yet been fully commercialized, and most charging infrastructures are still built based on wired charging systems.

Currently developed and standardized wireless charging systems have a rated capacity of 11 kW, which corresponds to a slow charger, and it takes approximately 5 to 8 hours to charge a typical electric vehicle. A 22 kW class system has also been developed but have not yet been standardized. The main reason wireless charging systems have not been commercialized is that their cost is too high compared to the charging speed. The main reason for the high cost is that the transmission pad has to be manufactured to have a large size to guarantee alignment error between the transmission and reception pads within a certain range, and in addition, safety functions, such as FOD, LOD, and PD are required. For these reasons, wireless charging systems are not only expensive but also suffer from reduced efficiency. The maximum efficiency of currently commercialized wireless chargers is around 90%, which is lower than the 94% efficiency of wired chargers. Furthermore, since wired slow chargers are lightweight and do not cause significant inconvenience to users, the low economic feasibility of introducing high-cost wireless charging systems in such a context may be pointed out as another reason for the delay in commercialization.

Meanwhile, with the advancement of autonomous driving technology and the imminent launch of robotaxis using electric vehicles, the need for automated charging solutions to charge unmanned taxis has emerged. Accordingly, market demand for wireless charging systems has increased again. Since robotaxis have to operate continuously to transport passengers, they cannot spend much time charging; it is desirable to complete charging within approximately 30 minutes. To achieve this, medium-capacity wireless chargers of 50 kW or more are required. Furthermore, if rapid wireless chargers in the 100 to 200 kW class may be developed at a low cost, there is sufficient potential for commercialization based on high convenience.

Current 11 to 22 kW wireless charging systems employ transmission and reception pads having a single-phase transformer. However, to implement medium-to-large capacity wireless charging of 50 kW or more, it is necessary to apply a three-phase transformer structure. In general, since the power density of a three-phase transformer is 1.7 times higher than that of a single-phase transformer, it is essential to adopt a three-phase transformer-type coil for medium-to-large capacity wireless charging.

To date, various coil structures have been proposed to implement three-phase transformers. In particular, a three-phase coil recently announced by Oak Ridge National Laboratory (ORNL) achieved a 300 kW capacity wireless charging system using a structure including three DD-type coils stacked in two layers. However, this structure still involves high-cost issues because the size of the transmission pad is very large and the shape of the coil is complex.

In addition, WiPowerOne disclosed, through Korean Application Publication No. 10-2023-0109588, a multi-feed coil structure including a primary coil, a first auxiliary coil having a width smaller than half the width of the primary coil, a length identical to the length of the primary coil, and disposed to overlap the primary coil, and a second auxiliary coil having a width smaller than half the width of the primary coil, a length identical to the length of the primary coil, and disposed to overlap the primary coil while not overlapping the first auxiliary coil. Although this structure is characterized by implementing a relatively small area occupied by the feed coil, it still possesses the limitation of high manufacturing costs due to the complex coil structure.

Therefore, to cope with the upcoming robotaxi era, a 50 kW class medium-speed wireless charging solution is required, and to replace highly inconvenient wired fast chargers, a 100 to 200 kW class fast wireless charging solution is required. To realize this, it is necessary to develop a three-phase transmission/reception pad structure that features a simple design while simultaneously achieving low cost and high efficiency.

### [Disclosure]

### [Technical Problem]

The present invention provides high-efficiency, low-cost three-phase transmission and reception pads for medium-to-large capacity wireless charging.

### [Technical Solution]

To achieve the above objects, the present invention aims to minimize the size of three-phase transmission/reception pads and achieve low cost and high efficiency by reducing an allowable range of horizontal misalignment between the transmission/reception pads and minimizing a vertical air gap to simplify the shape of the three-phase transmission and reception coils.

The present invention provides a three-phase magnetic flux pad including three coils arranged on a plane so as not to overlap each other, wherein the three coils are arranged adjacent to each other, and adjacent portions between the coils are configured to be parallel to each other, each coil includes an internal core arranged inside the coil, three connection cores connecting the three internal cores are provided at the rear portions of the adjacent portions of each of the three coils, and the three internal cores and the three connection cores are connected to each other in an overlapping manner and are configured to have a structure overlapping by a width greater than a thickness of the connection core to form a three-phase coil.

In the present invention, each of the three coils is configured flat on a single plane, and the internal cores are provided inside the three coils and disposed on the same plane as the three coils.

At this time, a wing core connected to the internal core is additionally provided below or above outer portions of the three adjacently arranged coil assemblies.

Also, in the present invention, the three coils are configured such that the outer portions of the three adjacently arranged coil assemblies are bent onto the same plane as the connection cores, and the internal cores are configured such that one side thereof is connected to the connection cores while the outer side thereof extends to an upper portion of the outer portion of each coil.

Also, the three coils and the three internal cores are accommodated and fixed in a tray formed of a non-metallic material, and the non-metallic tray is formed with grooves corresponding to windings of each coil and each internal core.

Also, the three-phase magnetic flux pad is formed to include a heat sink corresponding to the three coils and all cores, a resonant circuit corresponding to each coil is provided on a rear surface of the heat sink of each coil, both ends of each coil winding are drawn out toward a central portion in which the three coils are adjacent and then extracted between two connection cores adjacent to each coil so as to be connected to the resonant circuit corresponding to each coil disposed on the rear surface of the heat sink.

### [Advantageous Effects]

The three-phase magnetic flux pad with a three-phase coil structure according to the present invention may achieve high power density and high efficiency, while also enabling low-cost construction, accelerating the commercialization of medium- to large-capacity wireless charging.

### [BRIEF DESCRIPTION OF THE DRAWINGS]

FIG. 1 is a diagram illustrating a configuration of a conventional 11kW class single-phase magnetic flux pad.
FIG. 2 is a diagram illustrating a configuration of a conventional single-phase reception coil and a resonant circuit.
FIG. 3 is a diagram illustrating a configuration of a conventional three-phase magnetic flux pad.
FIGS. 4 to 7 are diagrams illustrating coil and core configurations of a three-phase magnetic flux pad according to various embodiments of the present invention.
FIG. 8 is a diagram illustrating magnetic flux paths according to each configuration of the three-phase magnetic flux pad shown in FIGS. 4 to 7.
FIG. 9 is a diagram illustrating an overall assembly view of a three-phase magnetic flux pad according to the present invention.
FIG. 10 is a diagram illustrating a cooling water piping for water cooling a heat sink according to the present invention.
FIG. 11 is a diagram illustrating a configuration of a three-phase reception coil and a resonant circuit according to the present invention.
FIG. 12 is a diagram illustrating an overall power circuit including three-phase transmission/reception coils according to the present invention.

### [Best Mode]

Embodiments of the present invention will now be described in detail with reference to the accompanying drawings. The following detailed description is merely illustrative and does not limit the embodiments of the present invention.

The present invention proposes a new three-phase magnetic flux pad structure capable of wireless power transfer with high efficiency, high power density, and low cost. In the present invention, the magnetic flux pad may be either a transmission pad or a reception pad.

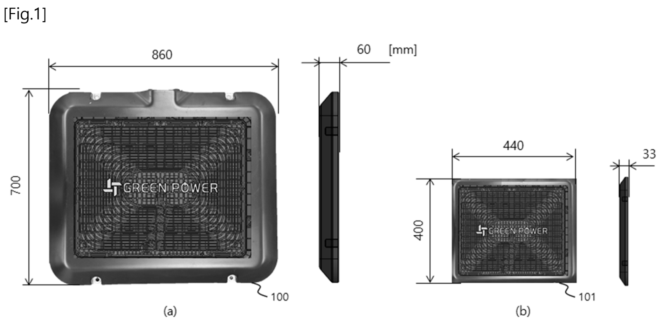

FIG. 1 illustrates a structure and size of a conventional 11 kW class single-phase wireless charging transmission/reception pad. In the related art, the sizes of a transmission pad 100 and the reception pad 101 are designed to be very large in order to secure a wide horizontal alignment tolerance range (X: ±7.5 cm, Y: ±10 cm) and vertical alignment tolerance range (11 to 16 cm from the ground). In particular, the size of the transmission pad 100 is relatively large because the vertical alignment error range is much wider than the horizontal alignment error range. Consequently, if an electric vehicle is not positioned correctly during parking, the transmission pad 100 may become so large as to be stepped on.

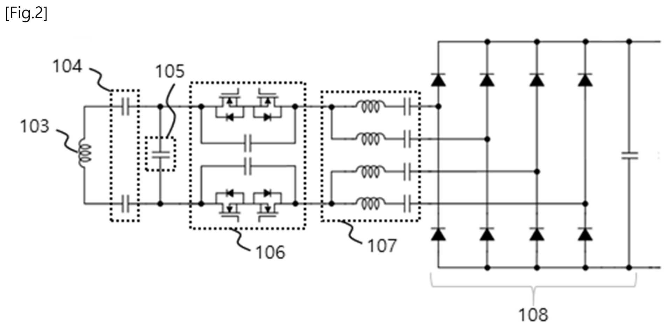

FIG. 2 illustrates an example diagram of a resonant circuit and rectifier connected to a reception coil in a conventional 11 kW class single-phase wireless charging transmission/reception pad. The reception coil 103 is connected to a series resonant capacitor 104 for resonance, and a parallel resonant capacitor 105 is connected in parallel to both ends of this series resonant capacitor. A tunable matching network (TMN) 106 capable of adjusting impedance in real time is connected to an output terminal thereof.

The TMN 106 operates on the principle of electrically adjusting the capacitance of the series resonant capacitor 104 by providing a bidirectional switch at both ends of the series resonant capacitor 104 to control the ratio of short-circuit of the series resonant capacitor. Two LC series resonant circuits are added to an output terminal of the TMN 106 to flatten the gain characteristics of power transfer. As shown in FIG. 2, a power circuit included in the reception pad 101 is considerably complex in order to ensure a wide horizontal alignment and vertical alignment tolerance range.

In addition, the transmission pad 100 includes functions, such as foreign object detection (FOD) and living object detection (LOD). In the case of FOD, an array of a plurality of small coils is placed on the upper surface of the transmission pad 100, and the presence of foreign objects is determined by detecting changes in inductance that occur when a metallic foreign object is placed on each coil. The LOD function may be implemented through radar signal transmission/reception or capacitance change detection methods. Realizing these FOD and LOD functions requires complex circuits and a large number of components, which consequently increases the overall system cost.

Furthermore, a position detection (PD) function is additionally used to recognize a relative position between the transmission pad 100 and the reception pad 101. This function operates by detecting a relative position through mutual position matching between a small coil installed in the reception pad 101 and an FOD coil of the transmission pad 100.

As such, conventional 11 kW class wireless chargers have very high manufacturing costs relative to their capacity, and as a result, their commercialization has not been made smoothly to date.

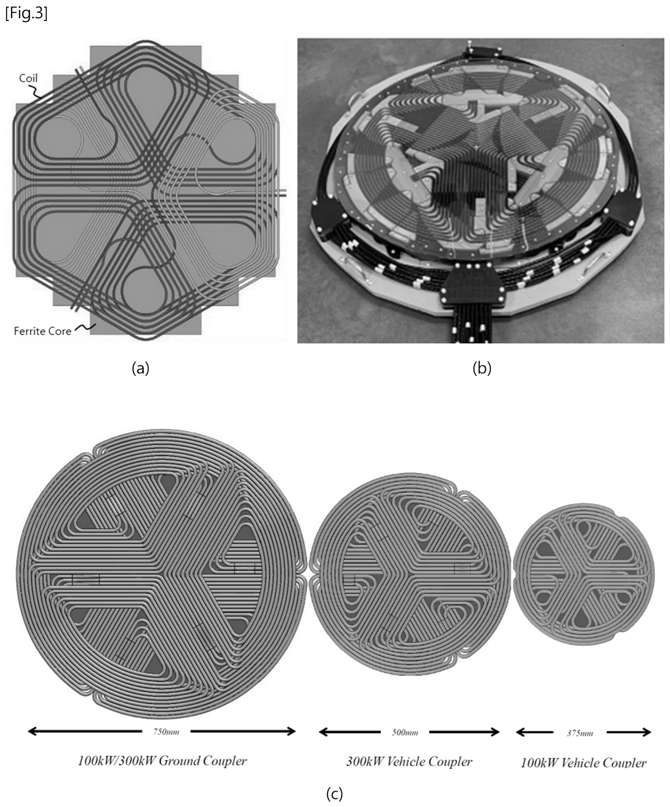

FIG. 3 illustrates a configuration of a conventional three-phase magnetic flux pad.

FIG. 3 shows a three-phase coil structure recently announced by Oak Ridge National Laboratory. Referring to FIG. 3(a), a three-phase coil is configured on a single plane, an identical three-phase coil is rotated 60 degrees and stacked thereon, and a single-phase coil of a first layer is connected to the corresponding opposite-side single-phase coil of a second layer to configure a DD coil. In other words, a three-phase pad is constructed by grouping the opposite coils of the first and second layers to form three DD-coils. FIG. 3(b) shows an actual pad, and FIG. 3(c) shows the sizes of the transmission and reception pads by capacity.

Since this method is based on a three-phase coil, it has a high power density approximately 1.7 times higher than a single-phase structure. In addition, it has the advantage that the pad size is not excessively large, despite being a 300 kW class wireless charging system. However, it has drawbacks, such as a highly complex coil structure and a lack of effective cooling means for heat generated by a cable. Furthermore, essential functions, such as FOD, LOD, and PD have not been implemented. Nevertheless, the complex structure leads to high manufacturing costs.

In order to solve these conventional problems, the present invention proposes high-efficiency, low-cost three-phase transmission and reception pads for medium-to-high capacity wireless charging. More specifically, the present invention aims to provide a three-phase coil structure for a three-phase magnetic flux pad that simultaneously achieves high power density and high efficiency while being manufactured at low cost, thereby making it applicable to medium-to-large capacity wireless charging.

To this end, the three-phase magnetic flux pad according to the present invention may be configured to include three coils, three internal cores, and three connection cores. More specifically, the three-phase magnetic flux pad of the present invention includes three coils arranged on a single plane not to overlap each other, and each coil is disposed adjacent to one another with their adjacent portions formed in parallel. Furthermore, an internal core is provided inside each coil, and three connection cores connecting the internal cores to each other are provided at the rear of the portions in which the coils are adjacent. The internal cores and the connection cores are coupled in an overlapping manner, and in this case, the overlapping portion may be formed with a width wider than the thickness of the connection core.

To this end, the three-phase magnetic flux pad according to the present invention may be configured to include three coils, three internal cores, and three connecting cores. More specifically, the three-phase magnetic flux pad of the present invention includes three coils arranged in a plane so as not to overlap each other. Each coil is arranged adjacent to each other, but with adjacent portions parallel to each other. Furthermore, an internal core is provided inside each coil, and three connecting cores are provided behind the adjacent portions of each coil to connect the internal cores. The internal cores and connecting cores overlap and are joined, and the overlapping portions may be formed with a width wider than the thickness of the connecting cores.

Hereinafter, the structure of the three-phase magnetic flux pad according to the present invention will be described in more detail with reference to the drawings.

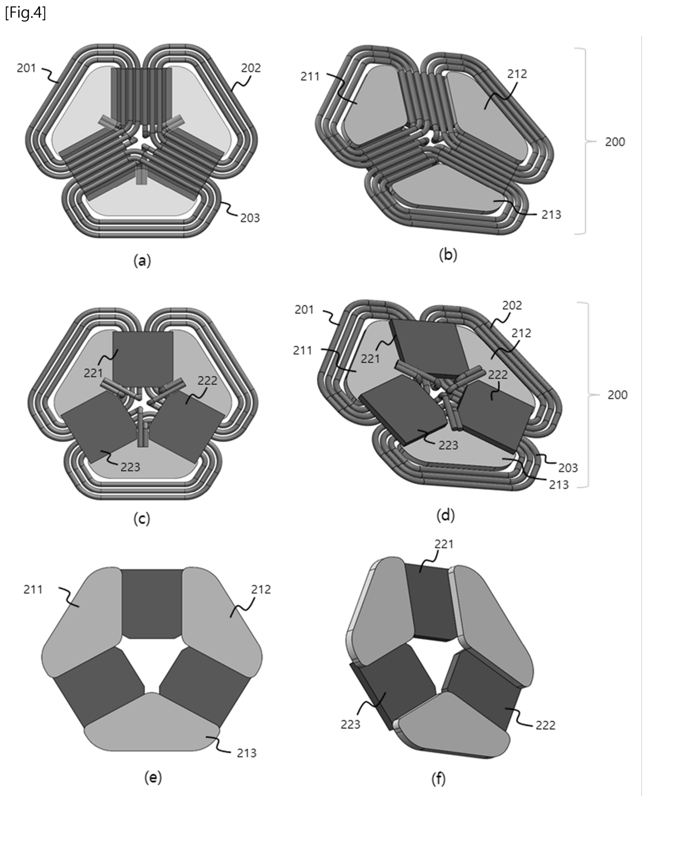

FIG. 4 is a diagram illustrating a basic structure of a three-phase magnetic flux pad according to the present invention.

In the basic structure, a three-phase magnetic flux pad 200 is configured such that each of three coils 201, 202, and 203 is arranged flat on a plane to form three phases, with each coil arranged at an angle of 120 degrees from the other. Each coil 201, 202, and 203 includes a plurality of windings, which may be spaced apart while maintaining a constant spacing.

Preferably, in the present invention, when the three coils 201, 202, and 203 are arranged adjacently, the overall outer shape is configured to form a cubic shape, thereby allowing the entire outer shape of the three-phase magnetic flux pad 200 to also form a cubic shape. However, without being limited thereto, for example, the three-phase magnetic flux pad 200 may also have a circular outer shape. However, when a cubic structure is used, a corner rounding section in which the winding of each coil is bent may be formed more gently than in a circular structure, resulting in improved mass production in the three-phase magnetic flux pad manufacturing process.

The three coils 201, 202, and 203 respectively include internal cores 211, 212, and 213 positioned on the same plane with each coil. The internal cores 211, 212, and 213 do not need to completely fill the coil interior.

Furthermore, three connection cores 221, 222, and 223 may be provided at the rear of the adjacent portions of the three coils to connect the three internal cores 211, 212, and 213.

The connection cores 221, 222, and 223 are implemented with a certain distance from the coils 201, 202, and 203, and the three internal cores 211, 212, 213 are formed to partially overlap and connected to the three connection cores 221, 222, and 223. At this time, preferably, the three internal cores 211, 212, and 213 and the three connection cores 221, 222, and 223 may be formed in a structure in which the overlapping cross-sectional area is wider than the thickness of the connection cores 221, 222, and 223. In the present invention, the magnetic flux introduced through the internal cores 211, 212, and 213 has the maximum magnetic flux, and this magnetic flux moves to another adjacent internal core through the connection cores 221, 222, and 223. At this time, the connection cores 221, 222, and 223 are required to have a sufficient thickness so as not to be saturated even at the maximum magnetic flux, and when overlapping and connecting to the internal cores 211, 212, and 213, the overlapping portion has to be greater than the cross-sectional area of the connection cores 221, 222, and 223 so as not to cause a bottleneck of the magnetic flux. In the present invention, the cross-sectional area in which the internal cores 211, 212, and 213 and the connection cores 221, 222, and 223 overlap each other acts as a passage for magnetic flux flow. Therefore, by implementing the cross-sectional area in which the internal cores 211, 212, and 213 and the connection cores 221, 222, and 223 overlap each other to be wider than the cross-sectional area of the connection cores 221, 222, and 223, a flux bottleneck phenomenon may be prevented.

The core assembly, in which three internal cores 211, 212, and 213 and three connection cores 221, 222, and 223 are connected, includes a central hollow space through which output cables of the three coils 201, 202, and 203 may be routed to the rear of a core without overlapping with the coils.

Meanwhile, when the connection cores 221, 222, and 223 are configured in a square shape, a triangular empty space is formed in the central portion of a core assembly. At this time, the output cable of the coil is drawn out to the central triangular empty space and may be configured to be routed to the rear surface of the internal cores 211, 212, and 213 of respective coils 201, 202, and 203 through the portions in which the connection cores 221, 222, and 223 face each other. Here, if the space in which the connection cores 221, 222, and 223 face each other is insufficient, the corners of the portions in which the connection cores 221, 222, and 223 face each other may be removed to secure space for the output cable of the coil to pass through.

In the three-phase magnetic flux pad of the present invention, the internal cores 211, 212, and 213 face each other between the transmission pad and the reception pad and perform the function of receiving the magnetic flux flowing into the coil during wireless power transmission, and the connection cores 221, 222, and 223 perform the function of causing the magnetic flux entering through the internal cores 211, 212, and 213 to turn backward through the connection cores 221, 222, and 223 and to come out through the internal cores of the other phase.

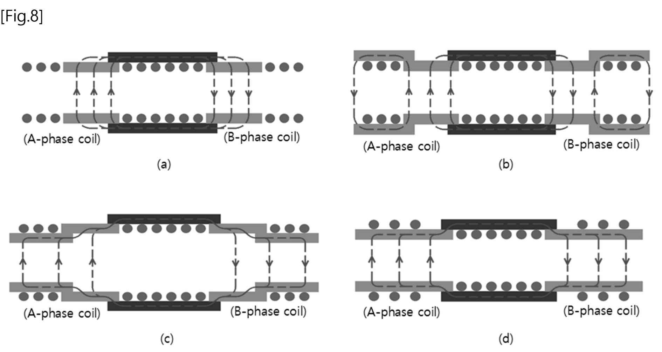

Referring to FIG. 8(a), in the case of the basic structure of the three-phase magnetic flux pad 200 according to the present invention, the internal cores of the transmission pad and the reception pad are arranged to face each other, and as an air gap between the transmission and reception pads is implemented within 40 mm, magnetic flux flow therebetween, and a flow of magnetic flux is formed such that the magnetic flux entering through an internal core returns to another adjacent internal core via the connection core adjacent to the corresponding internal core, thereby configuring a three-phase coil.

Meanwhile, the basic structure of the three-phase magnetic flux pad according to the present invention may cause the area of the internal core to become excessively narrow during the coil winding process, resulting in insufficient flux inflow. Enlarging the size of the three-phase magnetic flux pad to secure the flux inflow area may increase both the size of the three-phase magnetic flux pad and manufacturing costs, and thus, additional design is required to address this issue. Accordingly, another embodiment of the present invention proposes various improved structures that may expand the area of the internal core by modifying the basic structure of the three-phase magnetic flux pad, thereby increasing the flux inflow area.

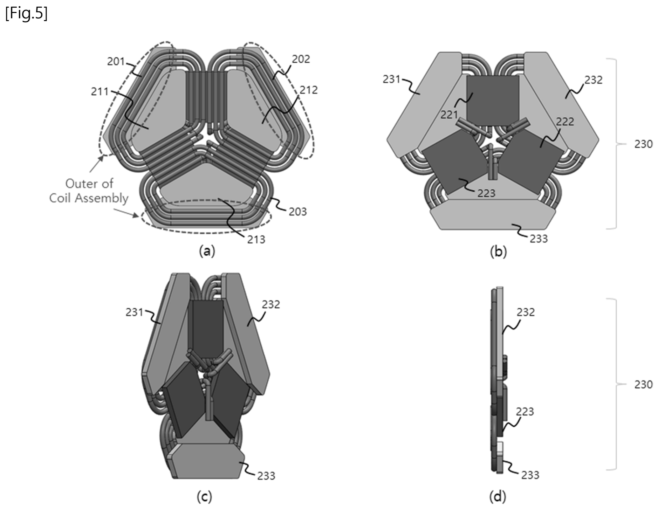

FIG. 5 is a diagram illustrating a wing-core under-type structure of a three-phase magnetic flux pad according to another embodiment of the present invention.

A three-phase magnetic flux pad 230 with the wing-core under-type structure, like the basic model, includes three coils 201, 202, and 203, three internal cores 211, 212, and 213, and three connection cores 221, 222, and 223. Since the structure and function of the coils and each core are identical to those of the basic model, a detailed description thereof will be omitted.

However, the wing-core under-type structure differs from the basic type in that the outer lower portions of the adjacently arranged coil assemblies are directly connected to the internal cores 211, 212, and 213 and the lower wing cores 231, 232, and 233, which are arranged on the same plane as the connection cores 221, 222, and 223, are added.

The lower wing cores 231, 232, and 233 are formed to be connected to the outer side of the internal cores 211, 212, and 213, thereby obtaining the effect of expanding the effective cross-sectional area of the internal cores 211, 212, and 213. That is, by adding the lower wing cores 231, 232, and 233, the area available for flux inflow into the internal core may increase, through which the problem of insufficient internal core area that may occur in the basic structure may be effectively solved.

For example, referring to FIG. 8(b), it can be seen that, when magnetic flux is coupled between the transmission pad and the reception pad, additional magnetic flux paths are formed in the regions of both side surfaces in which the lower wing cores 231, 232, and 233 are disposed, in addition to the flux flow formed in the central portion as in the basic structure. This corresponds to the effect of expanding the internal core area, and as a result, a more stable magnetic flux flow is secured across the entire three-phase coil.

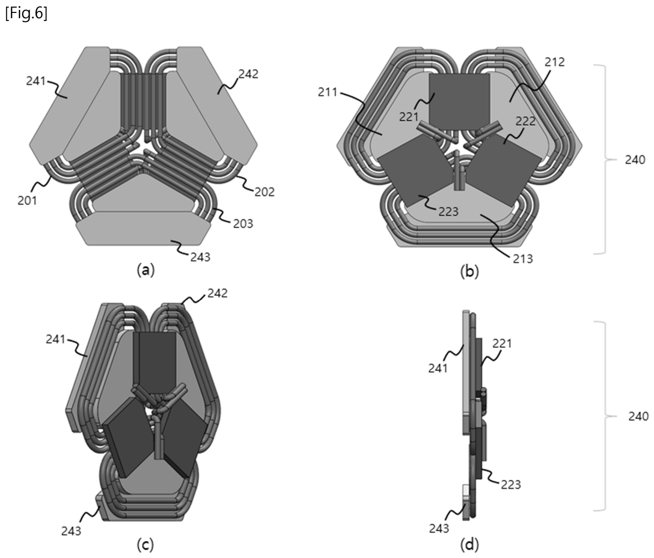

FIG. 6 is a diagram illustrating a wing-core upper-type structure of a three-phase magnetic flux pad according to another embodiment of the present invention.

The three-phase magnetic flux pad 240 of the wing-core upper-type structure has a structure in which a wing core is additionally disposed, similar to the wing-core under-type structure, but is different in the placement of the wing core and the corresponding functional effects.

Specifically, the wing core upper structure has the upper wing cores 241, 242, and 243 positioned on the outer portions of three coil assemblies positioned adjacent to each other, and the corresponding wing cores 241, 242, and 243 are connected to the upper side of the internal cores 211, 212, and 213 so as to be additionally formed in a direction in which the internal cores expand.

Unlike the under-type structure, this wing-core upper-type structure provides the effect of expanding the upper area of the internal core and inducing the flux to be distributed more widely in the outward direction, rather than aiming to form a new magnetic flux path. For example, referring to FIG. 8(c), when magnetic flux is coupled between the transmission and reception pads, the flux flowing into the internal core of the transmission pad forms a main flux path circulating along the internal and connection cores, identical to the basic structure. However, in the wing-core upper-type structure, since the upper portions of the internal cores 211, 212, and 213 are expanded by the upper wing cores 241, 242, and 243, the magnetic flux expands toward the upper wing cores 241, 242, and 243 while flowing along the internal cores, increasing the width of the flow, and as a result, the magnetic flux distribution spreads evenly not only in the center but also to the upper outer region.

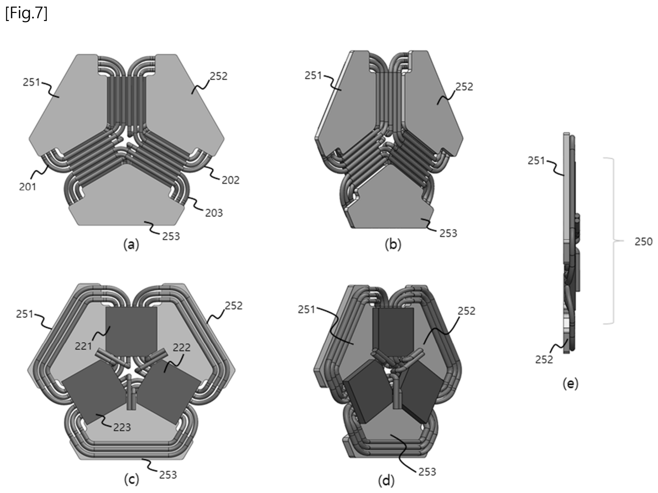

FIG. 7 is a diagram illustrating an internal-core extended-type structure of a three-phase magnetic flux pad according to still another embodiment of the present invention.

The three-phase magnetic flux pad 250 of the internal-core extended-type structure differs structurally from the aforementioned wing-core under-type and upper-type structures in that it is configured by extending the internal core itself instead of adding a separate wing-core.

To this end, in the internal-core extended-type structure, the outer portions of the three adjacently disposed coil assemblies are formed to be bent and positioned on the same plane as the connection cores 221, 222, and 223, and the internal cores 251, 252, and 253 may be configured such that one side is connected to the connection cores 221, 222, and 223, while the outer side extends upwardly of the outer portions of each coil assembly. To implement this, the outer portions of the coil assemblies may be formed to be bent downwardly so as to be naturally accommodated to a lower portion of the outer ends of the internal cores 251, 252, and 253.

Referring to FIG. 8(d), in the internal-core extended-type structure, since the upper area of the internal cores 251, 252, and 253 themselves is expanded, it can be seen that the magnetic flux transmitted through the air gap between the transmission and reception pads is distributed widely in the upper outer direction of the internal cores 251, 252, and 253. In this regard, the internal-core extended-type structure provides an effect similar to the aforementioned wing-core upper-type structure in terms of the functional aspect of flux distribution expansion. That is, it has the effect of increasing flux stability by widening the overall width of the magnetic flux flow.

However, since the internal-core extended-type is a method of expanding the internal core itself rather than adding wing cores, the number of core layers may be reduced and the structure becomes simpler compared to the wing-core under-type or upper-type. As a result, there is an advantage in that the entire three-phase magnetic flux pad may be manufactured in a slimmer and more compact form.

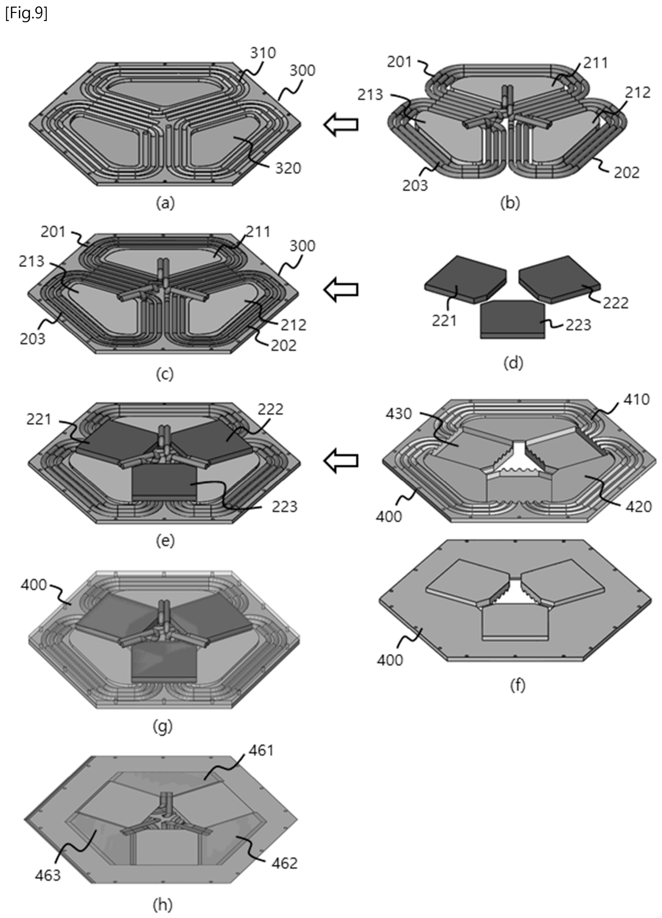

FIG. 9 is a diagram illustrating an overall assembly view of a three-phase magnetic flux pad according to the present invention. Meanwhile, in describing the overall assembly view below, the basic structure of the three-phase magnetic flux pad shown in FIG. 4 is used as an example, but the present invention is not limited thereto. For example, components, such as a non-metallic tray and heat sink described below may be equally applied to three-phase magnetic flux pads of other structures illustrated in FIGS. 5 to 7.

In the present invention, the three coils 201, 202, and 203 and the three internal cores 211, 212, and 213 may be implemented in a form in which they are preferably accommodated and fixed in a non-metallic tray 300. To this end, grooves 310 and 320 corresponding to the windings of each coil and each internal core may be provided on the non-metallic tray 300.

For example, referring to 9(a), the non-metallic tray 300 forms grooves 310 and 320 so that the windings of the respective coils 201, 202, and 203 and the respective internal cores 211, 212, and 213 may be inserted approximately halfway, and the windings of the respective coils 201, 202, and 203 and the respective internal cores 211, 212, and 213 may be inserted and fixed in the grooves 310 and 320. Such an accommodation structure using the tray 300 has the effect of stably fixing the windings of the respective coils 201, 202, and 203 and the respective internal cores 211, 212, and 213 to the designated position without shaking.

Accordingly, as shown in FIGS. 9(a) to 9(e), the three-phase magnetic flux pad 200 may be configured by first fixing the three coils 201, 202, and 203 and three internal cores 211, 212, and 213 to the tray 300 as shown in FIG. 9(c), and then stacking the three connection cores 221, 222, and 223 thereon as shown in FIG. 9(e).

Meanwhile, when the connection cores 221, 222, and 223 are stacked on the internal cores 211, 212, and 213, an air gap of a certain distance or more is formed at the overlapping portions, and the air gap between the respective internal cores 211, 212, and 213 and the connection cores 221, 222, and 223 may be finely adjusted so that the difference between the self-inductance of each coil and the coupling inductance between coils remains below a certain value. For example, the air gap may be fine-tuned by stacking spacers of a specific thickness between the respective internal cores 211, 212, and 213 and the respective connection cores 221, 222, and 223. This allows for compensation of core size errors that may occur during manufacturing, even without performing side machining after the internal core and connection core are molded.

At this time, the three-phase magnetic flux pad 200 according to the present invention is configured by stacking three coils 201, 202, and 203, three internal cores 211, 212, and 213, and three connection cores 221, 222, and 223 on a tray 300, and a molding liquid having a thermal conductivity above a certain level is poured to perform the first molding. Through this, the coils 201, 202, and 203 and the internal cores 211, 212, and 213 are stably fixed on the tray 300 without shaking, and thereafter, the air gap adjustment between the internal cores 211, 212, and 213 and the connection cores 221, 222, and 223 may be efficiently performed.

Furthermore, referring to FIG. 9(f), the three-phase magnetic flux pad 200 according to the present invention is configured by covering a heat sink 400 with an uneven portion formed to match the shapes of the respective coils 201, 202, and 203, the internal cores 211, 212, and 213, and the connection cores 221, 222, and 223 arranged on the tray 300, thereby effectively dissipating heat generated from the coils or cores. Meanwhile, if the three-phase magnetic flux pad includes wing cores, an additional uneven portion may be formed on the heat sink 400 to match the shapes of the three wing cores.

The heat sink 300 may preferably be formed of a metal material with excellent thermal conductivity, and an insulating coating may be formed on the heat sink 300 to ensure insulation between the windings of each coil, the internal core, and the connection core. Through this, the charging efficiency of the three-phase magnetic flux pad 200 may be improved, while simultaneously enhancing heat dissipation performance.

In addition, the heat sink 400 may be implemented in a form in which the central region of the heat sink 400, excluding the coils 201, 202, and 203, the internal cores 211, 212, and 213, and the connection cores 221, 222, and 223, is perforated so that the output terminal cables of the respective coils 201, 202, and 203 may be drawn out to the rear surface of the heat sink.

Furthermore, the heat sink 400 is electrically insulated from the coils 201, 202, and 203, the internal cores 211, 212, and 213, and the connection cores 221, 222, and 223, and by forming a plurality of fastening holes along the edges of the heat sink 400 and the tray 300 and securing them with bolts, the coils, cores, and the heat sink 400 may be implemented to maintain close contact with each other.

Meanwhile, in the present invention, after fixing the tray 300 and the heat sink 400, the three-phase magnetic flux pad 200 may be molded with a material that has excellent thermal conductivity and electrical insulation through the center of the heat sink 400, thereby efficiently conducting heat generated from the coils 201, 202, and 203 to the heat sink 400 and cooling it.

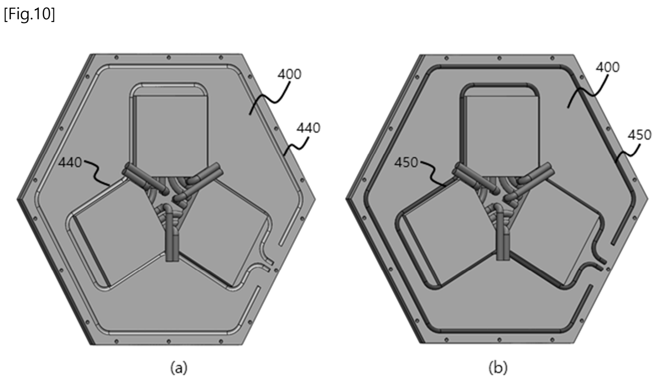

In addition, the heat sink 400 may include a water cooling piping 450 for water cooling on the rear surface to further improve heat dissipation performance. For example, as shown in FIGS. 10(a) and 10(b), a first pipe may be formed along the rear edge of the heat sink 400, and in addition, a second pipe may be formed along the edges of an internal core mounting groove protruding from the rear surface. To this end, grooves 440 may be formed on the rear surface of the heat sink 400 at positions corresponding to the first and second pipes, allowing each pipe to be half-inserted.

In the present invention, when the three-phase magnetic flux pad 200 is used as a reception pad, a resonant circuit and a rectifier may be provided on the rear surface of the heat sink 400 corresponding to each coil.

Referring to FIG. 9 (b), resonant circuit assemblies 461, 462, and 463 including a resonant circuit and a rectifier corresponding to the respective coil 201, 202, and 203 may be arranged on the rear surface of the heat sink 400. For example, a resonant circuit corresponding to the respective coils 201, 202, and 203 is installed on the rear surface of the heat sink of the respective coils 201, 202, and 203, and the cables at both ends of the respective coils 201, 202, and 203 are drawn out through the center of the heat sink 400 and then routed along between two adjacent connection cores so as to be electrically connected to the resonant circuit on the rear surface of the heat sink 400.

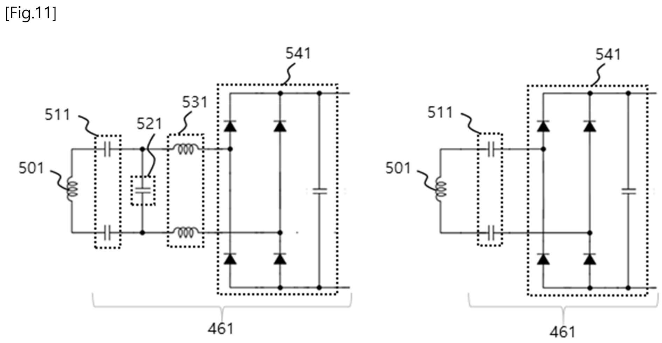

FIG. 11 is a diagram illustrating a configuration of a three-phase reception coil and a resonant circuit according to the present invention. Meanwhile, in describing FIG. 11, a first resonant circuit assembly 461 is used as an example, but other resonant circuit assemblies may also be equally applied.

Referring to FIG. 11, when a three-phase pad according to the present invention is used as a reception pad, three resonant circuit assemblies 461, 462, and 463 are included, and one resonant circuit assembly 461 may be configured to include a coil 501 of one phase, a resonant circuit, and a rectifier 541. The resonant circuit and rectifier 541 may be fixed to or molded on a heat sink 400 for efficient heat dissipation. Here, as shown in FIG. 11(a), the resonant circuit may be configured as a combination of a series resonant capacitor 511 connected in series with the coil 501, a parallel resonant capacitor 521, and a series inductor 531 connected in series again. In another embodiment, as shown in FIG. 10(b), the resonant circuit may include only a series resonant capacitor 511.

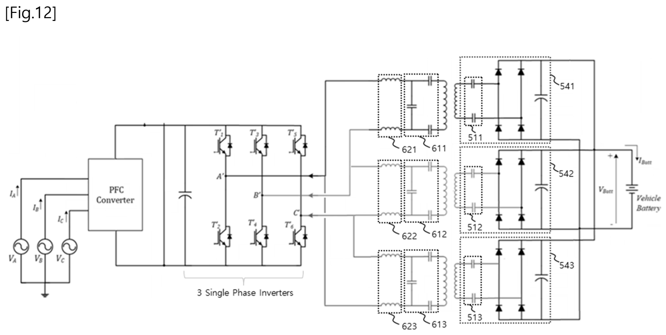

FIG. 12 is a diagram illustrating an example of the overall power circuit including the three-phase transmission and reception coils according to the present invention. When the three-phase pad of the present invention is used as a transmission pad, the resonant circuit assemblies 461, 462, and 463 may include series and parallel resonant capacitors. Since the series resonant inductor may be disposed on the inverter side, there is no need to place it in the transmission pad. In addition, the series and parallel resonant capacitors are molded into the heat sink 400, enabling heat dissipation through the heat sink 400.

Generally, to drive a three-phase transmission coil, it is often necessary to configure three single-phase inverters, which has disadvantages of high cost and low efficiency. In the present invention, the three-phase transmission coil may be driven by a single three-phase inverter, thereby providing the advantages of cost reduction and efficiency improvement.

Meanwhile, in the present invention, in the three-phase magnetic flux pad, the transmission and reception pads are arranged to face each other, and the air gap between both pads may be formed within 50 mm.

As described above, the embodiments of the present invention have been disclosed in the present specification and drawings. Although specific terms have been used, they are used in a general sense only to easily explain the technical contents of the present invention and to aid understanding and are not intended to limit the scope of the present invention. It is obvious to those skilled in the art to which the present invention pertains that other modifications based on the technical spirit of the present invention may be made in addition to the embodiments disclosed herein.

### [Description of Reference Numerals]

100: Single-phase transmission pad 101: Single-phase reception pad
103: Single-phase reception coil 104: Series resonant capacitor
105: Parallel resonant capacitor 106: TMN
107: Impedance compensation circuit 108: Single-phase rectifier circuit
200, 230, 240, 250: three-phase flux pads 201: First coil
202: Second coil 203; Third coil
211: First internal core 212: Second internal core
213: Third internal core 221: First connection core
222: Second connection core 223: Third connection core
231: First lower wing core 232: Second lower wing core
233: Third lower wing core 241: First upper wing core
242: Second upper wing core 243: Second upper wing core
251: First extended internal core 252: Second extended internal core
253: Third extended internal core
300: Tray 310: Tray coil groove
320: Tray internal core groove
400: Heat sink 410: Heat sink coil groove
420: Heat sink internal core groove 430: Heat sink connection core groove
440: First piping groove 450: Water cooling piping
461: First resonant circuit assembly 462: Second resonant circuit assembly
463: Third resonant circuit assembly 501, 502, 503: Single-phase coil
511, 512, 513: Series resonant capacitor
521, 522, 523: Parallel resonant capacitor 531, 532, 533: Resonant inductor
541, 542, 543: Rectifier 611, 612, 613: Series-parallel resonant circuit
621, 622, 623: Resonant inductor

## Claims

1. A three-phase magnetic flux pad for wirelessly transmitting or receiving power, the three-phase magnetic flux pad comprising:
three coils arranged on a plane so as not to overlap each other,
wherein the three coils are arranged adjacent to each other, and adjacent portions between the coils are configured to be parallel to each other,
each coil includes an internal core arranged inside the coil, three connection cores connecting the three internal cores are provided at the rear portions of the adjacent portions of each of the three coils, and the three internal cores and the three connection cores are connected to each other in an overlapping manner and are configured to have a structure overlapping by a width greater than a thickness of the connection core to form a three-phase coil.

2. The three-phase magnetic flux pad of claim 1, wherein the core assembly in which the three internal cores and the three connection cores are connected to each other is formed with an empty space in a central portion and is configured such that output cables of the three coils are drawn out to a rear side of a core through the empty space, without overlapping the coil.

3. The three-phase magnetic flux pad of claim 2, wherein,
when the connection core is configured in a rectangular shape, a triangular empty space is formed in the central portion of the core assembly, and
when the output cable of the coil is drawn out into the triangular empty space, the output cable is routed to a rear surface of the internal core of each coil through a portion in which the connection cores face each other, and when the space in which the connection cores face each other is insufficient, a corner of the portion in which the connection cores face each other is removed to secure a space for the output cable to pass through.

4. The three-phase magnetic flux pad of claim 1, wherein each of the three coils is configured flat on a single plane, and the internal core is provided inside the three coils and is provided on the same plane as the three coils.

5. The three-phase magnetic flux pad of claim 4, wherein a wing core connected to the internal core and provided on the same plane as the connection core is added below the outer portion of the three coil assemblies arranged adjacent to each other.

6. The three-phase magnetic flux pad of claim 4, wherein a wing core connected to the internal core and extending the internal core is added on an outer portion of the three coil assemblies arranged adjacent to each other.

7. The three-phase magnetic flux pad of claim 1, wherein the outer portions of the three coil assemblies arranged adjacent to each other are configured to be bent in the same plane as the connection core, and the internal core is configured such that one side thereof is connected to the connection core and an outer side thereof extends to an upper portion of the outer portion of each coil.

8. The three-phase magnetic flux pad of claim 1, wherein the three coils and the three internal cores are accommodated and fixed in a tray formed of a non-metallic material, and the non-metallic tray is formed with grooves corresponding to windings of each coil and each internal core.

9. The three-phase magnetic flux pad of claim 1, wherein the three-phase magnetic flux pad is provided with a heat sink having an uneven portion formed to correspond to the three coils, the three internal cores, and the three connection cores, and performs heat dissipation of the coils, the internal cores, and the connection cores, and a center of the heat sink is perforated to allow an output cable of each coil to be drawn out to a rear surface of the heat sink.

10. The three-phase magnetic flux pad of claim 1, wherein
the three-phase magnetic flux pad is further provided with a wing core connected to the internal core below or above an outer portion of the three coil assemblies arranged adjacent to each other, and
a heat sink having an uneven portion formed to correspond to the three coils, the three internal cores, the three connection cores, and the three wing cores is provided to perform heat dissipation of the coils, the internal core, and the connection core, and a center of the heat sink is perforated to allow an output cable of each coil to be drawn out to a rear surface of the heat sink.

11. The three-phase magnetic flux pad of claim 1, wherein the three-phase magnetic flux pad includes a heat sink corresponding to the coil and all cores, a resonance circuit corresponding to each coil is provided on the rear surface of the heat sink of each coil, and cables at both ends of each coil are drawn out through the center of the heat sink and connected to the resonance circuit arranged on the rear surface of the heat sink.

12. The three-phase magnetic flux pad of claim 11, wherein,
when the three-phase magnetic flux pad is used as a reception pad, a single-phase rectifier circuit is added to a resonant circuit output of each coil placed on the rear surface of the heat sink, and
output terminals of the three single-phase rectifier circuits are grouped to form a three-phase rectifier circuit.

13. The three-phase magnetic flux pad of claim 1, wherein the three-phase magnetic flux pad includes a heat sink corresponding to the coil and all cores, and the heat sink includes a pipe for water cooling on the rear surface of the heat sink.
